# DEMANDE DE BREVET EUROPEEN

(11) **EP 4 435 849 A1**
(43) Date de publication de la demande: **25.09.2024**
(21) Numéro de dépôt: 24163412.0
(22) Date de dépôt: 14.03.2024
(51) Int. Cl.: H01L 23/00

(54) **PROCÉDÉ DE COLLAGE**

(30) Priorité: 21.03.2023 FR 2302624
(71) Demandeur: Commissariat à l'énergie atomique et aux énergies alternatives, 75015 Paris (FR)
(72) Inventeur: SCANNELL, Mark, 38054 GRENOBLE Cedex 09 (FR)
(74) Mandataire: Brevalex

(57) **Abrégé**

Procédé de collage comprenant les étapes suivantes :
- fournir un premier substrat (100) comprenant une première face (101) comprenant un premier matériau diélectrique (110) et des plots métalliques (120),
- fournir un deuxième substrat (200) comprenant une première face (201) comprenant un deuxième matériau diélectrique (210), des plots métalliques (220), et une partie métallique (230),
- mettre en contact la première face (101) du premier substrat (100) avec la première face (201) du deuxième substrat (200), de manière à ce que, dans une première zone (Z1) les plots métalliques (120) du premier substrat (100) sont disposés en regard des plots métalliques (220) du deuxième substrat (200) et, dans une deuxième zone (Z2), les plots métalliques (120) du premier substrat (100) sont disposés en regard du deuxième matériau diélectrique (210) et la partie métallique (230) du deuxième substrat (200) est disposée en regard du premier matériau diélectrique (110),
- réaliser un traitement thermique.

## Description

### DOMAINE TECHNIQUE

La présente invention se rapporte au domaine général des procédés de collage, et en particulier des procédés de collage hybride.

L'invention concerne un procédé de collage.

L'invention concerne également une structure obtenue par un procédé de collage.

L'invention trouve des applications dans de nombreux domaines industriels, et notamment pour la fabrication des composants micro- et nano-électroniques.

L'invention est particulièrement intéressante puisqu'elle permet de faciliter les reprises de contact sur des assemblages obtenus avec un procédé de collage hybride.

### ÉTAT DE LA TECHNIQUE ANTÉRIEURE

Actuellement, pour créer des circuits intégrés empilés et connectés verticalement, le collage hybride (« hybrid bonding ») est mis en oeuvre.

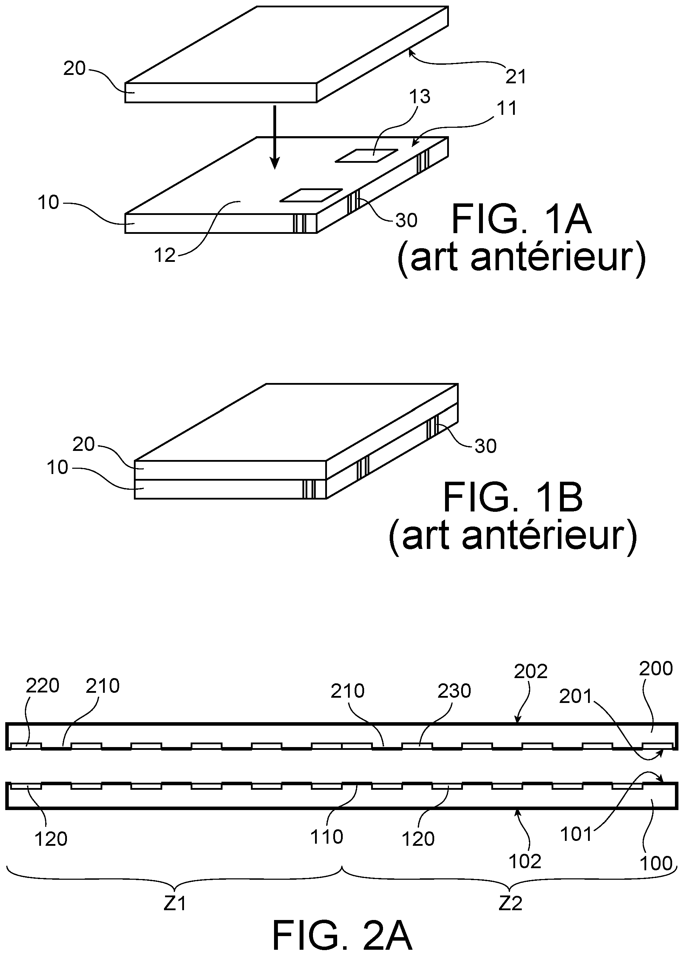

Comme représenté sur les figures 1A et 1B, ce type de collage consiste à coller l'un à l'autre deux substrats 10, 20 et plus particulièrement deux surfaces 11, 21, comprenant des plots métalliques 13 et un matériau isolant 12. Sous chaque surface, les plots métalliques 13 sont connectés aux transistors. En assemblant les substrats 10, 20, les zones métalliques entrent en contact et les transistors sont connectés de part et d'autre de l'interface.

Ce type de collage est particulièrement intéressant car il permet d'atteindre un pas d'interconnexion de l'ordre du micromètre et de fortes densités d'interconnexion.

Cependant, il nécessite l'utilisation de vias 30 traversant le silicium (ou TSV pour « through-silicon via ») car les contacts électriques sont inaccessibles après le collage (figures 1A et 1B).

Or, la fabrication des TSV nécessite de nombreuses étapes, ce qui augmente considérablement les coûts de fabrication et le nombre d'étapes du procédé (mise en oeuvre des TSV, traitement de la face arrière, révélation des TSV, couche de redistribution en face arrière (RDL pour « redistribution layer »).

### EXPOSÉ DE L'INVENTION

Un but de la présente invention est de proposer un procédé de collage remédiant aux inconvénients de l'art antérieur et permettant, notamment, de rendre facilement accessibles les contacts électriques.

Pour cela, la présente invention propose un procédé de collage comprenant les étapes suivantes :
- fournir un premier substrat comprenant une première face et une deuxième face, la première face du premier substrat comprenant un premier matériau diélectrique et des plots métalliques,
- fournir un deuxième substrat comprenant une première face et une deuxième face, la première face du deuxième substrat comprenant un deuxième matériau diélectrique, des plots métalliques, et une partie métallique,
- de préférence, réaliser un traitement de la première face du premier substrat et de la deuxième face du deuxième substrat (par exemple, un traitement par polissage et/ou activation par plasma),
- mettre en contact la première face du premier substrat avec la première face du deuxième substrat,
- réaliser un traitement thermique pour assembler le premier substrat au deuxième substrat.

Les plots métalliques du premier substrat, les plots métalliques du deuxième substrat et la partie métallique du deuxième substrat sont disposés de manière à ce que, lors de la mise en contact de la première face du premier substrat avec la première face du deuxième substrat deux zones soient formées :
- dans une première zone les plots métalliques du premier substrat sont disposés en regard des plots métalliques du deuxième substrat, et
- dans une deuxième zone les plots métalliques du premier substrat sont disposés en regard du deuxième matériau diélectrique et la partie métallique du deuxième substrat est disposée en regard du premier matériau diélectrique.

Avantageusement, le procédé comprend en outre une étape de retrait ultérieure au cours de laquelle la partie du deuxième substrat disposée au niveau de la deuxième zone est retirée.

L'invention se distingue fondamentalement de l'art antérieur par le positionnement particulier des plots métalliques des deux plaques ainsi que de la partie métallique du deuxième substrat. Ainsi, au niveau de la deuxième zone, il y a uniquement des interfaces métal/diélectrique. Il n'y a pas d'interface métal/métal ni d'interface diélectrique/diélectrique.

Dans une disposition classique, les plots métalliques seraient face à d'autres plots métalliques (collage métal/métal) et le matériau diélectrique face au matériau diélectrique (collage diélectrique/diélectrique).

Alors que les forces de collage diélectrique/diélectrique et métal/métal sont très fortes, le matériau diélectrique se lie mal au métal. Par exemple, la force de collage entre SiO₂ et Cu est très faible voire négligeable, pré- et post-recuit.

A titre illustratif, par exemple, en format 'pleine plaque', les forces de collage métal/métal sont de plus de 3J/m² pour Cu-Cu, après un recuit à 100°C, et les forces de collage pour SiO₂-SiO₂ sont d'environ 2J/m² après un recuit à 400°C. Pour des plaques complémentaires comprenant une surface diélectrique SiO₂ et des plots en Cu en vue d'un collage hybride, les forces de collage peuvent aller jusqu'à environ 6,5J/m² après un recuit de 400°C.

Avec la disposition selon l'invention, il est possible de libérerfacilement une partie du substrat supérieur (i.e. le deuxième substrat) après collage hybride et découpe pour révéler les plots électriques.

En effet, comme la première zone présente de fortes énergies de collage (d'une part, métal/métal et, d'autre part, diélectrique/diélectrique) et comme la deuxième zone présente des énergies de collage négligeables voire nulles (métal/diélectrique), la séparation de la partie du deuxième substrat au niveau de la deuxième zone est relativement simple à mettre en oeuvre.

Ainsi, lors de l'étape de retrait, la partie du deuxième substrat au niveau de la première zone reste collée au premier substrat et la partie du deuxième substrat au niveau de la deuxième zone se détache du premier substrat.

La mise en oeuvre d'un procédé qui élimine (et donc "gaspille") une surface importante de substrat semble à première vue désavantageuse. Cependant, dans ce procédé la valeur ajoutée de la partie collée justifie le sacrifice de la partie retirée et/ou la partie jetée peut être peu coûteuse (par exemple, il peut s'agir d'un dispositif passif).

Avec un tel procédé, il n'est pas systématiquement nécessaire de fabriquer des TSV, ni des RDL's.

Avantageusement, le premier matériau diélectrique est un oxyde ou un nitrure, de préférence un oxyde de silicium et/ou le deuxième matériau diélectrique est un oxyde ou un nitrure, de préférence un oxyde de silicium.

Avantageusement, les plots métalliques du premier substrat, les plots métalliques du deuxième substrat et/ou la partie métallique du deuxième substrat sont en cuivre.

Avantageusement, l'étape de retrait est réalisée selon les sous-étapes suivantes :
i) découper le deuxième substrat, par exemple à la scie, avec un laser ou par gravure chimique, la découpe étant réalisée de manière à pouvoir libérer la partie du deuxième substrat disposée au niveau de la deuxième zone,
ii) retirer la partie du deuxième substrat disposée au niveau de la deuxième zone.

Avantageusement, la sous-étape ii) est réalisée en collant un élément adhésif sur le deuxième substrat.

Selon une première variante avantageuse, la sous-étape ii) est réalisée en collant un élément adhésif sur la partie du deuxième substrat disposée au niveau de la deuxième zone.

Selon une autre variante avantageuse, la sous-étape ii) est réalisée en collant un élément adhésif sur la totalité du deuxième substrat. La partie 'non-collée' (i.e. partie du deuxième substrat disposée au niveau de la deuxième zone) sera retirée avec l'élément adhésif.

Avantageusement, après le traitement thermique, le procédé comporte une étape au cours de laquelle le deuxième substrat est aminci depuis la deuxième face. Cette étape est, avantageusement, réalisée avant l'étape de retrait et/ou avant l'étape de découpe.

Avantageusement, les plots métalliques du premier substrat et/ou les plots métalliques du deuxième substrat ont une surface, de préférence carrée ou rectangulaire, la plus grande dimension de la surface étant comprise entre 1 µm et 1 mm. La surface des plots métalliques est, par exemple, comprise entre 3 µm² et 1 mm².

L'invention concerne également un dispositif comprenant un premier substrat assemblé avec un deuxième substrat :
- le premier substrat comprenant une première face et une deuxième face, la première face du premier substrat comprenant un premier matériau diélectrique et des plots métalliques, de préférence en cuivre,
- le deuxième substrat comprenant une première face et une deuxième face, la première face du deuxième substrat comprenant un deuxième matériau diélectrique et des plots métalliques, de préférence en cuivre, et une partie métallique, de préférence en cuivre,
la première face du premier substrat étant disposée en regard de la première face du deuxième substrat.

Dans une première zone, les plots métalliques du premier substrat sont disposés en regard des plots métalliques du deuxième substrat. Dans une deuxième zone, les plots métalliques du premier substrat sont disposés en regard du deuxième matériau diélectrique et la partie métallique du deuxième substrat est disposée en regard du premier matériau diélectrique.

Avantageusement, le premier matériau diélectrique est un oxyde ou un nitrure, de préférence un oxyde de silicium et/ou le deuxième matériau diélectrique est un oxyde ou un nitrure, de préférence un oxyde de silicium.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
Les figures 1A et 1B précédemment décrites, représentent, de manière schématique, différentes étapes d'un procédé de collage selon l'art antérieur.
Les figures 2A, 2B, 2C, 2D et 2E représentent, de manière schématique, différentes étapes d'un procédé de collage selon un mode de réalisation particulier de l'invention.
La figure 3 représente, de manière schématique, en trois dimensions, une étape d'un procédé de collage selon un autre mode de réalisation particulier de l'invention.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et pouvant se combiner entre elles.

En outre, dans la description ci-après, des termes qui dépendent de l'orientation, tels que « dessus », « dessous », etc. d'une structure s'appliquent en considérant que la structure est orientée de la façon illustrée sur les figures.

### EXPOSÉ DÉTAILLÉ DE MODES DE RÉALISATION PARTICULIERS

Bien que cela ne soit aucunement limitatif, l'invention trouve particulièrement des applications dans le domaine de la microélectronique.

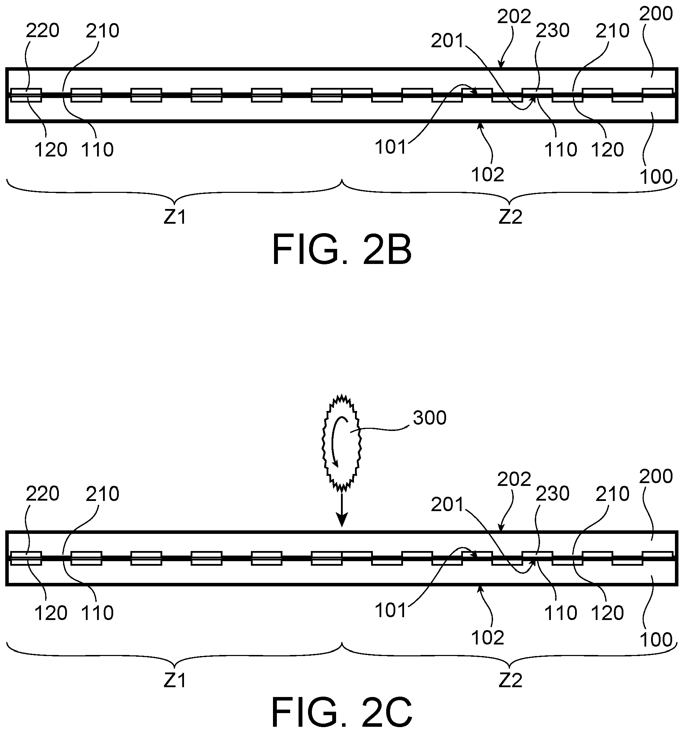

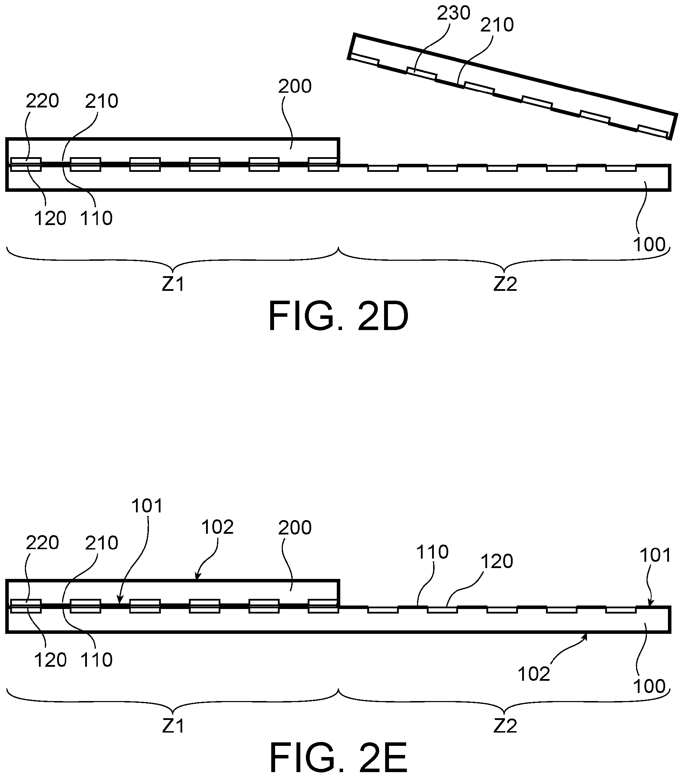

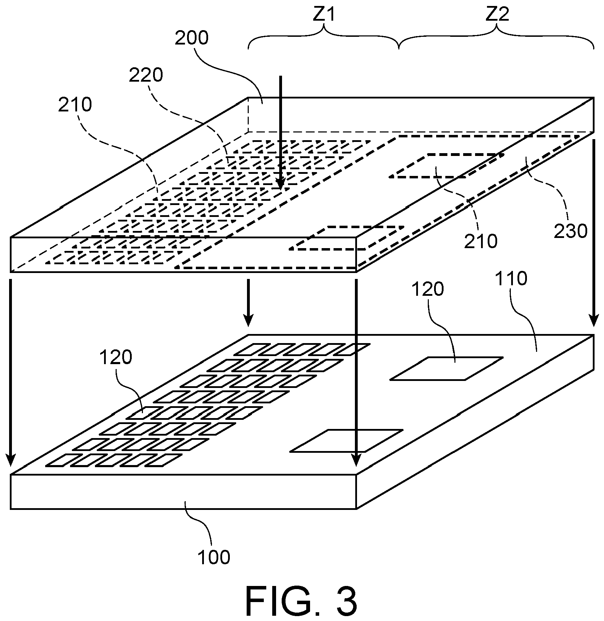

Le procédé de collage comprend les étapes suivantes (figures 2A à 2E et figure 3) :
a) fournir un premier substrat 100 comprenant une première face 101 et une deuxième face 102, la première face 101 du premier substrat 100 comprenant un premier matériau diélectrique 110 et des plots métalliques 120,
b) fournir un deuxième substrat 200 comprenant une première face 201 et une deuxième face 202, la première face 201 du deuxième substrat 200 comprenant un deuxième matériau diélectrique 210, des plots métalliques 220 et une partie métallique 230,
b') de préférence, réaliser un traitement des deux faces destinées à être mises en contact (par exemple par polissage et/ou activation par plasma) pour les rendre directement collables entre elles ('bondable'), par des forces Van der Waals,
c) mettre en contact la première face 101 du premier substrat 100 avec la première face 201 du deuxième substrat 200; la mise en contact des deux substrats conduisant à la formation de deux zones :
   - dans une première zone Z1, les plots métalliques 120 du premier substrat 100 sont disposés en regard des plots métalliques 220 du deuxième substrat 200,
   - dans une deuxième zone Z2, les plots métalliques 120 du premier substrat 100 sont disposés en regard du deuxième matériau diélectrique 210 et la partie métallique 230 du deuxième substrat 200 est disposée en regard du premier matériau diélectrique 110,
d) réaliser un traitement thermique pour assembler le premier substrat 100 au deuxième substrat 200; le traitement thermique permettant d'augmenter les forces d'adhésion entres les surfaces et de réduire la résistivité entre les plots métalliques par recristallisation,
e) de préférence, retirer une partie du deuxième substrat 200 pour libérer au moins une partie des plots métalliques 120 du premier substrat 100.

Les substrats 100, 200 fournis à l'étape a) et à l'étape b) comprennent chacun deux faces principales : une première face 101, 201 et une deuxième face 102, 202. Ces faces sont parallèles ou sensiblement parallèles entre elles.

Les substrats 100, 200 sont, par exemple, des plaques ('wafers').

La première face 101, 201 de chaque substrat 100, 200 est, avantageusement, plane pour augmenter les liaisons directes diélectrique/diélectrique et métal/métal (forces de Van der Waals).

La première face 101, 201 de chaque substrat 100, 200 comprend un matériau diélectrique 110, 210 et des plots métalliques 120, 220.

Les plots métalliques 120, 220 peuvent recouvrir le matériau diélectrique 110, 210. Les plots métalliques 120, 220 peuvent pénétrer dans le matériau diélectrique 110, 210. Les plots métalliques 120, 220 peuvent traverser l'épaisseur du matériau diélectrique 110, 210.

Les plots métalliques 120, 220 d'un même substrat 100, 200 sont électriquement isolés les uns des autres par le matériau diélectrique 110, 210.

Les plots métalliques 120, 220 peuvent être régulièrement espacés.

La surface des plots 120, 220 peut être de toute forme. Elle est, de préférence, carrée ou rectangulaire. La plus grande dimension de la surface des plots 120, 220 est, par exemple, comprise entre 1 µm et 3 mm, de préférence entre 1µm et 1 mm.

Par exemple, pour un carré la plus grande dimension est le côté. Pour un rectangle, la plus grande dimension est la longueur.

Au niveau de la première zone, les plots métalliques 120 du premier substrat 100 et les plots métalliques 220 du deuxième substrat 200 sont identiques et disposés de la même façon sur les substrats, de manière à ce que, lors de l'assemblage, ils soient en regard les uns des autres.

Concernant le premier substrat 100, les plots de la première zone Z1 peuvent être identiques ou différents des plots de la deuxième zone Z2.

Lorsque les plots sont différents :
- la plus grande dimension de la surface des plots 120 de la première zone Z1 est, de préférence, comprise entre 1 µm et 15 µm, encore plus préférentiellement entre 3 et 10 µm ; ces plots sont des plots dits d'intersection entre les puces,
- la plus grande dimension de la surface des plots 120 de la deuxième zone Z2 est, de préférence, comprise entre 20 µm et 3mm, de préférence entre 50 µm et 1 mm ; ces plots servent à connecter électriquement le dispositif à un élément extérieur au dispositif.

De préférence, les plots de la première zone Z1 sont identiques aux plots de la deuxième zone Z2. Par exemple, la plus grande dimension de la surface des plots 120 de la première zone Z1 et la plus grande dimension de la surface des plots de la deuxième zone Z2 sont comprises entre 1 µm et 3mm, de préférence entre 1µm et 1mm, encore plus préférentiellement entre 1µm et 15 µm, et encore plus préférentiellement entre 3 et 10 µm.

Les plots métalliques 120 du premier substrat 100 et les plots métalliques 220 du deuxième substrat 200 peuvent être en un même matériau ou en des matériaux différents. Les plots métalliques 120, 220 sont, par exemple, en Cu, W, Al, Ti, Ta, Ge, Ga ou un de leurs alliages. De préférence, les plots métalliques 120, 220 sont en cuivre.

Au niveau de la deuxième zone Z2, le deuxième substrat 200 comprend en outre une partie métallique 230. La partie métallique 230 a une forme complémentaire des plots métalliques 120 du premier substrat 100 disposés au niveau de la deuxième zone Z2. Par exemple, il s'agit d'une couche métallique comprenant des ouvertures ayant la forme des plots 120 du premier substrat de la deuxième zone Z2, et positionnées de telle sorte que, lors de la mise en contact des substrats 100, 200, les ouvertures sont en regard de ces plots (figure 3).

La partie métallique 230 est, par exemple, en Cu, W, Al, Ti, Ta, Ge, Ga ou un de leurs alliages. De préférence, elle est en cuivre.

Le premier matériau diélectrique 110 et le deuxième matériau diélectrique 210 peuvent être identiques ou différents.

De préférence, le premier matériau diélectrique 110 et le deuxième matériau diélectrique 210 sont des oxydes. De préférence, il s'agit d'oxyde de silicium. Il pourrait également s'agir de dioxyde de germanium ou d'un oxyde de SiGe, ou encore de Ta₂O₅, Al₂O₃, ZrO₂ ou de HfO₂.

Selon un autre mode de réalisation préférentiel, le premier matériau diélectrique 110 et le deuxième matériau diélectrique 210 sont des nitrures. Par exemple, il peut s'agir d'un nitrure SiNₓ.

Le matériau diélectrique 110, 210 de chaque substrat 100, 200 est recouvert localement par des plots métalliques 120, 220.

Entre l'étape b) et l'étape c), une étape de polissage est, avantageusement, réalisée pour obtenir un premier substrat 100 et/ou un deuxième substrat 200 ayant des surfaces planes. Par exemple, cette étape peut être réalisée par polissage mécano-chimique (ou CMP pour « Chemical Mechanical Polishing »).

Les plots métalliques 120 du premier substrat 100, les plots métalliques 220 du deuxième substrat 200 et la partie métallique 230 du deuxième substrat sont disposés de manière à ce que, lors de l'étape c), deux zones soient formées.

Dans une première zone (notée Z1 sur les figures), les plots métalliques 120 du premier substrat 100 sont disposés en regard des plots métalliques 220 du deuxième substrat 200. Le premier matériau diélectrique 110 est donc disposé en regard du deuxième matériau diélectrique 210. Dans la zone Z1, il y a deux types de collage métal/métal, d'une part, et, d'autre part, diélectrique/diélectrique.

Dans une deuxième zone (notée Z2 sur les figures), les plots métalliques 120 du premier substrat 100 sont disposés en regard du deuxième matériau diélectrique 210 et la partie métallique 230 du deuxième substrat 200 est disposée en regard du premier matériau diélectrique 110. Dans la zone Z2, il y a un seul type de collage : le collage métal/diélectrique.

Au niveau de cette deuxième zone Z2, une tolérance de recouvrement entre le premier matériau diélectrique 110 et la partie métallique 230 du deuxième substrat 200 et/ou entre le deuxième matériau diélectrique 210 et les plots 120 du premier substrat 100 peut être acceptée. La tolérance est, de préférence, inférieure à 5%, encore plus préférentiellement inférieure à 2%, de manière encore plus préférentielle inférieure à 1%. Par inférieure à 5%, on entend que moins de 5% de la surface de chaque plot métallique est recouverte par un matériau diélectrique. Par exemple, le décalage peut être entre 2 et 20 nm. Autrement dit, le premier matériau diélectrique 110 et la partie métallique 230 du deuxième substrat 200 et/ou le deuxième matériau diélectrique 210 et les plots 120 du premier substrat 100 peuvent se recouvrir sur une longueur de recouvrement comprise entre 2 nm et 20 nm.

La première zone Z1 et la deuxième zone Z2 peuvent représenter chacune environ 50% de la surface des substrats. La proportion de chaque zone pourra être adaptée en fonction du dispositif final désiré. Par exemple, Z1 peut représenter 80% de la surface des substrats et Z2 20% de la surface des substrats.

Lors de l'étape d), le traitement thermique est, par exemple, réalisé à une température comprise entre 200°C et 400°C. Cette étape augmente les énergies d'adhésion au niveau de la première zone Z1.

Même après l'étape d), les énergies d'adhésion au niveau de la deuxième zone Z2 restent faibles voire négligeables.

La différence d'énergie d'adhésion entre la première zone Z1 et la deuxième zone Z2 est plus importante après recuit qu'avant recuit.

A l'issue de l'étape d), la partie des substrats 100, 200 au niveau de la deuxième zone Z2 (zone dite non collée) est maintenue mécaniquement par la partie des substrats 100, 200 au niveau de la première zone Z1 (zone dite collée).

Avantageusement, après l'étape d), le procédé comprend en outre une étape e) au cours de laquelle la partie du deuxième substrat 200 disposée au niveau de la deuxième zone Z2 est retirée.

L'étape de retrait est réalisée selon les sous-étapes suivantes :
i) découper le deuxième substrat 200, par exemple, à la scie, avec un laser ou par gravure chimique, la découpe étant réalisée de manière à pouvoir libérer la partie du deuxième substrat 200 au niveau de la deuxième zone Z2,
ii) retirer la partie du deuxième substrat 200 au niveau de la deuxième zone Z2.

Lors de l'étape i), un découpage est réalisé à la frontière de la première zone Z1 et de la deuxième zone Z2 pour séparer le deuxième substrat 200 en deux parties.

L'étape i) peut être réalisée par une technique de sciage classique. Une scie 300 est, par exemple, représentée sur la figure 2C. L'étape i) peut être réalisée par d'autres techniques, par exemple par une étape de gravure laser et/ou par gravure chimique. La sous-étape ii) conduit, avantageusement, à la formation d'une tranchée allant de la première face 201 à la deuxième face 202 du deuxième substrat 200.

La sous-étape ii) peut être réalisée en collant un élément adhésif sur la partie du deuxième substrat 200 positionnée au niveau de la deuxième zone Z2.

Alternativement, la sous-étape ii) peut être réalisée en collant un élément adhésif sur la totalité du deuxième substrat 200. Lorsque l'élément adhésif est retiré, les zones non collées vont partir avec l'élément adhésif, les zones collées ne bougeront pas.

Il pourrait également être possible de retirer la partie non collée du deuxième substrat 200 par un moyen hydraulique (projection d'eau et/ou d'air), par enlèvement chimique (acides), par expansion thermique (incluant l'expansion thermique locale appliquée par laser), par contraction thermique (traitement froid), ou par une combinaison de ces possibilités.

Entre l'étape d) et l'étape e), le procédé peut comporter une étape au cours de laquelle le deuxième substrat 200 est aminci depuis la deuxième face 202.

L'amincissement peut être obtenu par meulage classique, par gravure chimique, par ions réactifs ou par une combinaison de ces techniques.

Ainsi, à l'issue de l'étape d), on obtient un dispositif comprenant un premier substrat 100 assemblé avec un deuxième substrat 200 :
- le premier substrat 100 comprenant une première face 101 et une deuxième face 102, la première face 101 du premier substrat 100 comprenant un premier matériau diélectrique 110 et des plots métalliques 120, de préférence en cuivre,
- le deuxième substrat 200 comprenant une première face 201 et une deuxième face 202, la première face 201 du deuxième substrat 200 comprenant un deuxième matériau diélectrique 210, des plots métalliques 220, de préférence en cuivre, et une partie métallique 230, de préférence en cuivre.

La première face 101 du premier substrat 100 est disposée en regard de la première face 201 du deuxième substrat 200.

Dans une première zone Z1, les plots métalliques 120 du premier substrat 100 sont disposés en regard des plots métalliques 220 du deuxième substrat 200.

Dans une deuxième zone Z2, les plots métalliques 120 du premier substrat 100 sont disposés en regard du deuxième matériau diélectrique 210 et la partie métallique 230 du deuxième substrat 200 est disposée en regard du premier matériau diélectrique 110.

A l'issue de l'étape e), on obtient un dispositif comprenant le premier substrat 100 (dit substrat de base) recouvert localement par le deuxième substrat 200 au niveau de la première zone Z1. Au niveau de la deuxième zone Z2, les plots métalliques 120 du premier substrat 100 sont exposés et donc accessibles pour réaliser une reprise de contact.

Le procédé peut en outre comprendre une ou plusieurs des étapes suivantes : nettoyage des plots (si nécessaire), découpage et emballage.

## Revendications

1. Procédé de collage comprenant les étapes suivantes :
- fournir un premier substrat (100) comprenant une première face (101) et une deuxième face (102), la première face (101) du premier substrat (100) comprenant un premier matériau diélectrique (110) et des plots métalliques (120),
- fournir un deuxième substrat (200) comprenant une première face (201) et une deuxième face (202), la première face (201) du deuxième substrat (200) comprenant un deuxième matériau diélectrique (210), des plots métallique (220) et une partie métallique (230),
- mettre en contact la première face (101) du premier substrat (100) avec la première face (201) du deuxième substrat (200),
- réaliser un traitement thermique pour assembler le premier substrat (100) au deuxième substrat (200),
**caractérisé en ce que** les plots métalliques (120) du premier substrat (100), les plots métalliques (220) et la partie métallique (230) du deuxième substrat (200) sont disposés de manière à ce que, lors de la mise en contact de la première face (101) du premier substrat (100) avec la première face (201) du deuxième substrat (200), dans une première zone (Z1) les plots métalliques (120) du premier substrat (100) sont disposés en regard des plots métalliques (220) du deuxième substrat (200) et dans une deuxième zone (Z2) les plots métalliques (120) du premier substrat (100) sont disposés en regard du deuxième matériau diélectrique (210) et la partie métallique (230) du deuxième substrat (200) est disposée en regard du premier matériau diélectrique (110)
et **en ce que** le procédé comprend en outre une étape de retrait ultérieure au cours de laquelle la partie du deuxième substrat (200), disposée au niveau de la deuxième zone (Z2), est retirée.

2. Procédé selon la revendication 1, **caractérisé en ce que** le premier matériau diélectrique (110) est un oxyde ou un nitrure, de préférence un oxyde de silicium et/ou **en ce que** le deuxième matériau diélectrique (210) est un oxyde ou un nitrure, de préférence un oxyde de silicium.

3. Procédé selon l'une quelconque des revendications précédentes, **caractérisé en ce que** les plots métalliques (120) du premier substrat (100), les plots métalliques (220) et/ou la partie métallique (230) du deuxième substrat (200) sont en cuivre.

4. Procédé selon l'une quelconque des revendications 1 à 3, **caractérisé en ce que** l'étape de retrait est réalisée selon les sous-étapes suivantes :
i) découper le deuxième substrat (200) par exemple à la scie, avec un laser ou par gravure chimique, la découpe étant réalisée de manière à pouvoir libérer la partie du deuxième substrat (200) disposée au niveau de la deuxième zone (Z2),
ii) retirer la partie du deuxième substrat (200) au niveau de la deuxième zone (Z2).

5. Procédé selon la revendication 4, **caractérisé en ce que** la sous-étape ii) est réalisée en collant un élément adhésif sur le deuxième substrat (200).

6. Procédé selon l'une quelconque des revendications précédentes, **caractérisé en ce que**, après le traitement thermique, le procédé comporte une étape au cours de laquelle le deuxième substrat (200) est aminci depuis la deuxième face (202).

7. Procédé selon l'une quelconque des revendications précédentes, **caractérisé en ce que** les plots métalliques (120) du premier substrat (100) et/ou les plots métalliques (220) du deuxième substrat (200) ont une surface, de préférence carrée ou rectangulaire, la plus grande dimension de la surface étant comprise entre 1 µm et 1 mm.

8. Dispositif comprenant un premier substrat (100) assemblé avec un deuxième substrat (200) :
- le premier substrat (100) comprenant une première face (101) et une deuxième face (102), la première face (101) du premier substrat (100) comprenant un premier matériau diélectrique (110) et des plots métalliques (120), de préférence en cuivre,
- le deuxième substrat (200) comprenant une première face (201) et une deuxième face (202), la première face (201) du deuxième substrat (200) comprenant un deuxième matériau diélectrique (210), des plots métalliques (220), de préférence en cuivre, et une partie métallique (230), de préférence en cuivre,
la première face (101) du premier substrat (100) étant disposée en regard de la première face (201) du deuxième substrat (200),
**caractérisé en ce que**, dans une première zone (Z1), les plots métalliques (120) du premier substrat (100) sont disposés en regard des plots métalliques (220) du deuxième substrat (200) et, dans une deuxième zone (Z2), les plots métalliques (120) du premier substrat (100) sont disposés en regard du deuxième matériau diélectrique (210) et la partie métallique (230) du deuxième substrat (200) est disposée en regard du premier matériau diélectrique (110).

9. Dispositif selon la revendication précédente, **caractérisé en ce que** le premier matériau diélectrique (110) est un oxyde ou un nitrure, de préférence un oxyde de silicium et/ou **en ce que** le deuxième matériau diélectrique (210) est un oxyde ou un nitrure, de préférence un oxyde de silicium.
